# EUROPÄISCHE PATENTANMELDUNG

(11) **EP 4 592 886 A1**
(43) Veröffentlichungstag der Anmeldung: **30.07.2025**
(21) Anmeldenummer: 24221364.3
(22) Anmeldetag: 19.12.2024
(51) Int. Cl.: G06F 30/20, G05B 17/02, G06F 9/52, G05B 23/02, G06F 11/36

(54) **SYNCHRONISIEREN EINER SIMULATION EINES REALEN GERÄTS MIT EINEM TEST**

(30) Priorität: 24.01.2024 DE 102024101969
(71) Anmelder: dSPACE GmbH, 33102 Paderborn (DE)
(72) Erfinder: Bostanci, Erkan, 33102 Paderborn (DE); Jürgens, Hartmut, 33102 Paderborn (DE)

(57) **Zusammenfassung**

Die Erfindung betrifft ein computerimplementiertes Verfahren zum Synchronisieren einer Simulation mit einem Test, wobei die Simulation auf Eingangsdaten hin Ausgangsdaten liefert, umfassend die folgenden Verfahrensschritte:
S1) Übertragen eines Eingangsdatums von dem Test an die Simulation, so dass von der Simulation ein Ausgangsdatum ermittelt wird, gleichzeitiges Starten einer Testzeit sowie einer Simulationszeit, so dass eine verstrichene Testzeit und eine verstrichene Simulationszeit abrufbar sind, und Übertragen des ermittelten Ausgangsdatums von der Simulation an den Test,
S2) Abrufen der Testzeit sowie Abrufen der Simulationszeit und Vergleich der Simulationszeit mit der Testzeit,
S3a) wenn der Vergleich erbracht hat, dass die Simulationszeit der Testzeit entspricht oder diese übersteigt: Übertragen eines weiteren Eingangsdatums aus der vorbestimmten Menge von Eingangsdaten von dem Test an die Simulation, so dass von der Simulation auf das weitere Eingangsdatum hin ein weiteres Ausgangsdatum ermittelt wird, oder Beenden des Verfahrens, wenn alle Eingangsdaten bereits an die Simulation übertragen worden sind, und
S3b) wenn der Vergleich erbracht hat, dass die Simulationszeit geringer ist als die Testzeit: Pausieren des Tests für eine Pausenzeit, in der der Ablauf der Testzeit angehalten wird, und Wiederholen von Schritt S2 und nachfolgend von Schritt S3a oder S3b nach der Pausenzeit.

Auf diese Weise wird ein Verfahren bereitgestellt, das eine präzise Synchronisierung ermöglicht.

## Beschreibung

Die Erfindung betrifft ein computerimplementiertes Verfahren zum Synchronisieren einer Simulation eines realen Geräts mit einem Test, wobei die Simulation langsamer als beim Echtzeitbetrieb des realen Geräts in vordefinierter Weise auf von ihr empfangene Eingangsdaten hin solche Ausgangsdaten liefert, die das reale Gerät liefern würde, wenn es die Eingangsdaten empfangen hätte, und der Test eine vorbestimmte Menge von Eingangsdaten umfasst, die an die Simulation übertragen werden sollen.

Für die Automatisierung von Steuergerätetests, vornehmlich in der Entwicklung mechatronischer Systeme, existieren leistungsstarke Software-Lösungen. Eine davon ist das Produkt AutomationDesk der Anmelderin. Diese Software zeichnet sich durch eine Kombination aus fortschrittlichen Funktionen und nützlichen Vorteilen aus, die sie zu einem wertvollen Werkzeug in verschiedenen High-Tech-Branchen wie der Automobilindustrie macht. Ein wesentliches Merkmal dieser Software ist ihre benutzerfreundliche grafische Benutzeroberfläche, die es Anwendern ermöglicht, Testabläufe intuitiv zu erstellen, zu verwalten und auszuführen. Diese Oberfläche unterstützt die visuelle Programmierung und vereinfacht so den Prozess der Testkonfiguration erheblich. Darüber hinaus bietet die Software die Möglichkeit der skriptbasierten Testautomatisierung, wobei insbesondere Python unterstützt wird. Dies ermöglicht eine flexible und leistungsfähige Handhabung von Testabläufen, besonders bei der Bearbeitung komplexer Testszenarien.

Die Integration von Hardware-in-the-Loop (HiL)-Systemen ist ein weiteres Schlüsselmerkmal. Durch diese Integration können realitätsnahe Tests unter Laborbedingungen durchgeführt werden, was in der Entwicklungsphase von Steuergeräten von großem Vorteil ist. Dazu werden umfangreiche Bibliotheken mit vordefinierten Testblöcken und - funktionen angeboten, was das Erstellen von Testfällen erheblich erleichtert und beschleunigt. Ein weiterer Vorteil liegt in der Fähigkeit, anpassbare Testberichte zu generieren. Diese Berichte enthalten detaillierte Informationen über die Testergebnisse, Leistungsdaten und potenzielle Fehlerquellen, was eine effiziente Analyse und Qualitätskontrolle ermöglicht. Insgesamt wird damit die Effizienz der Testprozesse erhöht, indem manueller Aufwand reduziert und gleichzeitig eine hohe Flexibilität in der Testgestaltung bereitgestellt wird. Die Möglichkeit, komplexe Testabläufe zu automatisieren und detaillierte Testberichte zu erstellen, verbessert die Testqualität und Zuverlässigkeit signifikant.

Darüber hinaus ist das sogenannten Step-based Testing bekannt, wofür die Anmelderin eine Software mit der Bezeichnung SIMPHERA anbietet. Hierbei handelt es sich um eine fortschrittliche Methode zur Organisation und Durchführung von Tests in der Entwicklung von Steuergeräten und mechatronischen Systemen. Diese Art des Testens basiert auf einem strukturierten Ansatz, bei dem Testfälle in einzelne, klar definierte Schritte unterteilt werden. Jeder Schritt repräsentiert eine spezifische Aktion oder Überprüfung, die im Rahmen des gesamten Testprozesses ausgeführt wird. Die Software ermöglicht es, Testabläufe in logische und übersichtliche Segmente zu gliedern, wodurch die Komplexität der Testentwicklung reduziert und die Nachvollziehbarkeit der Tests erhöht wird. Ein zentraler Aspekt ist dabei die Möglichkeit, Tests intuitiv zu konfigurieren und anzupassen. Die Testentwickler können die Testabläufe genau auf die spezifischen Anforderungen der zu testenden Systeme abstimmen. Dies trägt zu einer erhöhten Effektivität und Genauigkeit bei der Fehlersuche und Qualitätsbewertung bei. Die Software unterstützt zudem die Automatisierung der Testausführung, was eine zeitsparende und konsistente Durchführung von Testreihen ermöglicht. Die automatisierte Ausführung ist besonders vorteilhaft, da sie menschliche Fehler reduziert und eine hohe Reproduzierbarkeit der Testergebnisse gewährleistet. Ein weiterer wichtiger Aspekt ist dabei die Fähigkeit, detaillierte Berichte und Analysen über die durchgeführten Tests zu generieren. Diese Berichte bieten wertvolle Einsichten in die Leistung und Zuverlässigkeit des getesteten Systems und sind entscheidend für die kontinuierliche Verbesserung der Produktqualität.

Im Bereich der Testautomatisierung, insbesondere bei der Verwendung von Testwerkzeugen der zuvor genannten Art, stellt die Synchronisierung zwischen Testablauf und Simulation eine wesentliche Herausforderung dar. Aktuelle Lösungen erfordern, dass Testabläufe und Simulationsprozesse synchronisiert werden, um eine effektive und realitätsnahe Testumgebung zu gewährleisten. Dies ist besonders wichtig, um sicherzustellen, dass die einzelnen Testschritte, die in Echtzeit ausgeführt werden, mit der Simulation übereinstimmen, unabhängig von der Komplexität der Simulation oder der Leistungsfähigkeit der Hardware.

Ein kritischer Aspekt in diesem Zusammenhang ist die Möglichkeit, dass die Simulation langsamer als in Echtzeit ablaufen kann. Dieses Ungleichgewicht zwischen der Geschwindigkeit der Simulation und der Echtzeit stellt eine erhebliche Herausforderung dar. In der Praxis bedeutet dies, dass Testentwickler zusätzliche Maßnahmen ergreifen müssen, um eine Desynchronisation zu vermeiden. Eine gängige Methode besteht darin, manuell Synchronisationspunkte in den Testablauf einzufügen. Diese Synchronisationspunkte dienen dazu, die Testschritte mit dem langsameren Simulationsverlauf in Einklang zu bringen.

Jedoch birgt dieser Ansatz verschiedene Probleme. Erstens erhöht das manuelle Einrichten von Synchronisationspunkten den Arbeitsaufwand und die Komplexität des Testprozesses erheblich. Zweitens führt es zu einer reduzierten Flexibilität und Effizienz, da die Testentwickler ständig die Synchronisation überwachen und gegebenenfalls anpassen müssen. Dies kann insbesondere bei komplexen oder sich dynamisch ändernden Testumgebungen zu Fehlern und Ineffizienzen führen. Drittens besteht das Risiko, dass die Synchronisation nicht genau genug ist, was zu ungenauen Testergebnissen und möglicherweise zu einer falschen Bewertung der Systemleistung führen kann.

Ein weiteres zentrales Problem in diesem Zusammenhang betrifft die zeitliche Steuerung der Datenübertragung zwischen Test und Simulation. Maßgeblich ist dabei, dass die Eingangsdaten, die an die Simulation übertragen werden sollen, zu bestimmten Zeitpunkten an die Simulation übertragen werden müssen. Ebenso wichtig ist auch die Gegenrichtung: Damit ein Test korrekt und aussagekräftig durchgeführt werden kann, müssen die von der Simulation generierten Daten ebenfalls zu genau definierten Zeitpunkten an den Test übertragen werden. Dies ist beispielsweise essenziell, wenn geprüft werden soll, ob ein Steuergerät innerhalb einer bestimmten Zeit nach einem definierten Ereignis erwartungsgemäß reagiert. In einem solchen Szenario muss der Test zu einem ersten Zeitpunkt ein bestimmtes Ereignis durch seinen Input an die Simulation auslösen und anschließend messen, ob das erwartete Ergebnis innerhalb einer festgelegten Zeitspanne aus der Simulation ausgelesen werden kann. Ohne eine präzise zeitliche Koordination zwischen der Simulation und dem Test könnten Verzögerungen oder Synchronisationsfehler auftreten, die die Aussagekraft des Tests erheblich beeinträchtigen und möglicherweise zu falschen Schlussfolgerungen über die Leistungsfähigkeit des Systems führen.

Insgesamt gilt also, dass der aktuelle Stand der Technik in Bezug auf die Synchronisierung von Testabläufen und Simulationen in den Testwerkzeugen der genannten Art zwar grundlegende Funktionalitäten bietet, jedoch durch den manuellen Einsatz und die damit verbundene Fehleranfälligkeit und Ineffizienz limitiert ist.

Davon ausgehend ist es die Aufgabe der Erfindung, ein Verfahren bereitzustellen, das eine präzise Synchronisierung ermöglicht, ohne die zuvor genannten Nachteile und Einschränkungen.

Diese Aufgabe wird durch den Gegenstand des Patentanspruchs 1 gelöst. Bevorzugte Weiterbildungen finden sich in den Unteransprüchen.

Erfindungsgemäß wird also ein computerimplementiertes Verfahren zum Synchronisieren einer Simulation eines realen Geräts mit einem Test bereitgestellt, wobei
die Simulation langsamer als beim Echtzeitbetrieb des realen Geräts in vordefinierter Weise auf von ihr empfangene Eingangsdaten hin solche Ausgangsdaten liefert, die das reale Gerät liefern würde, wenn es die Eingangsdaten empfangen hätte, und
der Test eine vorbestimmte Menge von Eingangsdaten umfasst, die an die Simulation übertragen werden sollen,
umfassend die folgenden Verfahrensschritte:
   S1) Übertragen eines Eingangsdatums aus der vorbestimmten Menge von Eingangsdaten von dem Test an die Simulation, so dass von der Simulation auf das Eingangsdatum hin wenigstens ein Ausgangsdatum ermittelt wird, gleichzeitiges Starten einer Testzeit in dem Test sowie einer Simulationszeit in der Simulation, so dass eine verstrichene Testzeit und eine verstrichene Simulationszeit ab der Übertragung des Datums von dem Test an die Simulation abrufbar sind, und Übertragen des ermittelten Ausgangsdatums von der Simulation an den Test,
   S2) Abrufen der verstrichenen Testzeit sowie Abrufen der verstrichenen Simulationszeit und Vergleich der verstrichenen Simulationszeit mit der verstrichenen Testzeit,
   S3a) wenn der Vergleich erbracht hat, dass die verstrichenen Simulationszeit der verstrichenen Testzeit entspricht oder diese übersteigt: Übertragen eines weiteren Eingangsdatums aus der vorbestimmten Menge von Eingangsdaten von dem Test an die Simulation, so dass von der Simulation auf das weitere Eingangsdatum hin wenigstens ein weiteres Ausgangsdatum ermittelt wird, oder Beenden des Verfahrens, wenn alle Eingangsdaten aus der vorbestimmten Menge von Eingangsdaten bereits an die Simulation übertragen worden sind, und
   S3b) wenn der Vergleich erbracht hat, dass die verstrichenen Simulationszeit geringer ist als die verstrichene Testzeit: Pausieren des Tests für eine Pausenzeit, in der der Ablauf der Testzeit angehalten wird, und Wiederholen von Schritt S2 und nachfolgend von Schritt S3a oder S3b nach der Pausenzeit.

Die Funktion des Tests liegt darin, das von der Simulation an den Test übertragene Ausgangsdatum, das auf das von dem Test an die Simulation übermittelte Eingangsdatum hin ermittelt worden ist, zu prüfen, und zwar z. B. dahingehend, ob es einen erwarteten Wert aufweist und/oder ob es innerhalb einer erwarteten Zeitdauer empfangen wird. Wenn es dabei heißt, dass das ermittelte Ausgangsdatum von der Simulation an den Test übertragen wird, so kann dies ein aktives Senden des Ausgangsdatums von der Simulation an den Test sein (Push). Im Allgemeinen wird der Test jedoch das Ausgangsdatum aus der Simulation auslesen (Pull). Es ist dabei erfindungswesentlich, dass ein solches computerimplementiertes Verfahren zum Synchronisieren einer Simulation eines realen Geräts mit einem Test bereitgestellt wird, das insbesondere Situationen berücksichtigt, in denen die Simulation langsamer als der Echtzeitbetrieb des realen Geräts läuft. Das Verfahren startet mit dem Übertragen eines oder mehrerer Eingangsdaten von dem Test an die Simulation (Schritt S 1). Diese Eingangsdaten können vielfältiger Natur sein und sind nicht auf Messdaten beschränkt. Nach der Übertragung dieser Daten starten sowohl eine Testzeit im Test als auch eine Simulationszeit in der Simulation. Diese Zeiten ermöglichen es, den Fortschritt von Test und Simulation nachzuvollziehen und zu vergleichen.

Im weiteren Verlauf des Verfahrens werden die verstrichene Testzeit sowie die verstrichene Simulationszeit abgerufen und miteinander verglichen (Schritt S2). Dieser Schritt ist entscheidend, um festzustellen, ob die Simulation mit der Testzeit Schritt hält. Wenn die verstrichene Simulationszeit der Testzeit entspricht oder diese übersteigt, wird ein weiteres Eingangsdatum an die Simulation übertragen (Schritt S3a). Dieser Prozess kann grundsätzlich wiederholt werden, bis alle Eingangsdaten übertragen wurden. Ist der Test abgeschlossen, endet das Verfahren. Falls jedoch die Simulationszeit hinter der Testzeit zurückbleibt, tritt Schritt S3b in Kraft. In diesem Fall wird der Test für eine Pausenzeit pausiert, während der die Testzeit angehalten wird. Nach dieser Pausenzeit werden die Schritte S2 und anschließend S3a oder S3b wiederholt.

Grundsätzlich ist es möglich, den Schritt S2 erst dann auszuführen, wenn Schritt S1 abgeschlossen ist, also wenn das ermittelten Ausgangsdatums von der Simulation an den Test übermittelt worden ist. Das ist jedoch nicht zwingend. Vielmehr ist es auch möglich, dass der Schritt S2 bereits dann ausgeführt wird, wenn zwar schon das Eingangsdatum von dem Test an die Simulation übermittelt worden ist, aber noch kein Ausgangsdatum ermittelt worden ist oder das ermittelte Ausgangsdatum noch nicht von der Simulation an den Test übertragen worden ist.

Das erfindungsgemäße Verfahren bietet den Vorteil, dass es eine flexible und effiziente Synchronisation zwischen Test und Simulation ermöglicht wird. Es trägt der Tatsache Rechnung, dass Simulationen aufgrund verschiedener Faktoren langsamer sein können als die Echtzeit. Durch die Einführung von Pausenzeiten, wenn die Simulation hinter dem Test zurückbleibt, wird sichergestellt, dass die Simulation die notwendige Zeit hat, um die entsprechenden Ausgangsdaten zu generieren, bevor weitere Eingangsdaten verarbeitet werden. Diese Vorgehensweise minimiert das Risiko von Desynchronisation und verbessert die Genauigkeit und Zuverlässigkeit der Testergebnisse. Sie eliminiert zudem den Bedarf an manuellen Anpassungen oder dem Einfügen von Synchronisationspunkten, was den Testprozess effizienter und weniger fehleranfällig macht.

Der Begriff "Synchronisieren" besagt vorliegend also nicht, dass der Test und die Simulation jederzeit vollkommen synchron ablaufen. Vielmehr ist hier gemeint, dass der Test ggf. auf die Simulation wartet, um der Simulation nicht vorauszueilen. Wesentlich ist, dass die Simulation auf das Eingangsdatum das entsprechende Ausgangsdatum bereits erstellt hat, bevor nachfolgend ein weiteres Eingangsdatum an die Simulation übertragen wird. Sollte die verstrichene Simulationszeit der verstrichenen Testzeit entsprechen, kann sofort der nächste Testbefehl an die Simulation übertragen werden.

Gemäß einer bevorzugten Weiterbildung der Erfindung ist vorgesehen, dass in Schritt S2 die Überprüfung der verstrichenen Test- und Simulationszeiten in vorbestimmten konstanten Zeitintervallen erfolgt. Diese regelmäßige Überprüfung ermöglicht eine fortlaufende und genaue Synchronisation zwischen Test und Simulation und sorgt dafür, dass die Synchronisierung dynamisch an die jeweiligen Laufzeiten angepasst wird. Vorzugsweise entspricht die Zeitdauer der Zeitintervalle der Zeitdauer der Pausenzeit. Dies schafft eine kohärente Struktur im Synchronisationsprozess und sorgt dafür, dass die Pausenzeiten optimal genutzt werden, um die Synchronität zwischen Test und Simulation aufrechtzuerhalten.

Gemäß einer bevorzugten Weiterbildung der Erfindung wird eine zusätzliche Anpassungsfähigkeit bereitgestellt, indem die Dauer der Zeitintervalle einstellbar ist. Dies bietet den Vorteil, dass die Genauigkeit der Synchronisation je nach Bedarf erhöht oder die Rechen- und Speicherintensität des Polling-Verfahrens verringert werden kann.

Vorzugsweise gilt weiterhin, dass die Testzeit in Echtzeit verstreicht, was die Relevanz und Realitätsnähe des Tests erhöht, indem sichergestellt wird, dass der Test den tatsächlichen Bedingungen des realen Geräts möglichst nahekommt. Vorzugsweise gilt außerdem, dass die Simulationszeit zumindest zeitweise in geringerer Zeit als in Echtzeit verstreicht. Diese Anpassung trägt der Tatsache Rechnung, dass die Geschwindigkeit der Simulation von der Rechenkapazität der verwendeten Hardware abhängen kann, was eine flexible Anpassung der Synchronisationsstrategie an die jeweilige Leistung der Hardware erfordert.

Gemäß einer bevorzugten Weiterbildung der Erfindung weist der Test parallele Stränge auf, in denen jeweils wenigstens ein Eingangsdatum von dem Test an die Simulation übertragen wird, so dass die Schritte S1, S2, S3a und S3b zeitlich nebeneinander in parallelen Strängen ablaufen. Dies ermöglicht es, im Rahmen des Tests mehrere Testprozesse gleichzeitig durchzuführen, wobei jeder Strang quasi einen eigenständigen Test darstellt, der parallel zu anderen Tests abläuft. Diese Parallelität erhöht die Effizienz und ermöglicht eine umfassendere und schnellere Testabdeckung.

Vorzugsweise werden die Eingangsdaten aus der vorbestimmten Menge von Eingangsdaten in einer vorbestimmten Reihenfolge an die Simulation übertragen. Dies sorgt für eine strukturierte und geordnete Testdurchführung, die für die Konsistenz und Nachvollziehbarkeit der Testergebnisse wesentlich ist. Vorzugsweise ist außerdem die Simulation eine Software-in-the-loop-Simulation.

Schließlich betrifft die Erfindung auch ein nichtflüchtiges, computerlesbares Speichermedium mit darauf abgespeicherten Befehlen, die bei ihrer Ausführung auf einem Prozessor ein Verfahren bewirken, wie zuvor beschrieben.

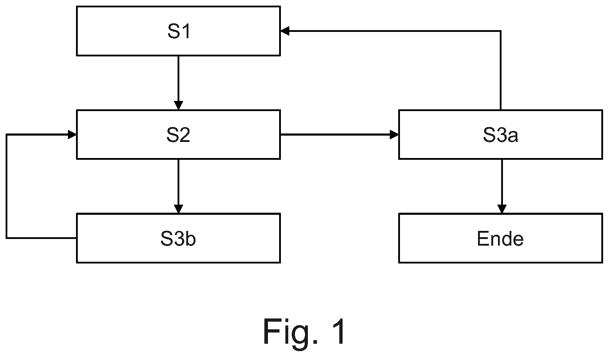

In der Zeichnung zeigt
- Fig. 1: schematisch den Ablauf eines Verfahrens gemäß einem bevorzugten Ausführungsbeispiel der Erfindung.

Vorliegend geht es um ein computerimplementiertes Verfahren zum Synchronisieren einer Simulation eines realen Geräts mit einem Test. Die Simulation eine Software-in-the-loop-Simulation, die langsamer als beim Echtzeitbetrieb des realen Geräts in vordefinierter Weise auf von ihr empfangene Eingangsdaten hin solche Ausgangsdaten liefert, die das reale Gerät liefern würde, wenn es die Eingangsdaten empfangen hätte. Wie üblich, umfasst der Test eine vorbestimmte Menge von Eingangsdaten, die an die Simulation übertragen werden sollen.

Das hier beschriebene Ausführungsbeispiel betrifft also auf ein Verfahren zur Synchronisation von Testabläufen mit Simulationsprozessen in Testwerkzeugen wie AutomationDesk oder SIMPHERA der Anmelderin, insbesondere bei Situationen, in denen die Simulationsgeschwindigkeit langsamer als in Echtzeit ist. Maßgeblich ist dabei ein Mechanismus, der eine automatische und nahtlose Synchronisation zwischen dem Testablauf und der Simulation sicherstellt, unabhängig von der Komplexität der Simulation oder der Leistungsfähigkeit der Hardware. Diese Lösung ermöglicht es, dass die Testschritte stets synchron zur Simulation ausgeführt werden, ohne dass ein Testentwickler manuell in den Prozess eingreifen muss, um Synchronisationsprobleme zu vermeiden.

Dazu sieht das Verfahren gemäß dem vorliegend beschriebenen bevorzugten Ausführungsbeispiel der Erfindung vor, dass der Testablauf durch einen Python-Interpreter ausgeführt wird. Hierbei wird über das sys-Modul eine trace-Funktion registriert, die es ermöglicht, jeden einzelnen Python-Befehl zu unterbrechen. Nach jedem Befehl wird der Zustand der Simulation überprüft und, falls erforderlich, eine Wartezeit eingeführt, bis die Simulation den entsprechenden Zeitpunkt erreicht hat. Dies gewährleistet, dass der Python-Interpreter und die Simulation nahezu synchron laufen, indem die abgelaufene Zeit im Python-Interpreter in Relation zur Simulationszeit gesetzt wird. Die kontinuierliche Überprüfung jedes Python-Befehls erlaubt eine feine Abstimmung der Ablaufzeiten, wodurch eine hochpräzise Synchronisation erreicht wird. Durch dieses Vorgehen wird die Notwendigkeit beseitigt, dass der Testentwickler manuell Synchronisationspunkte in den Testablauf einfügen muss, wodurch der Testprozess effizienter und zuverlässiger wird.

Ein konkretes Beispiel zur Veranschaulichung der Erfindung sieht wie folgt aus: Ein Testentwickler beabsichtigt, innerhalb eines Tests ein Signal, beispielsweise eine Warnblinkertaste, zu steuern. Das Signal soll für die Dauer einer Sekunde von 0 auf 1 gesetzt und anschließend wieder auf 0 zurückgesetzt werden. Im Rahmen des Testablaufs setzt der Testentwickler das Signal auf 1 und implementiert eine Warteanweisung, um eine Sekunde zu warten. Jedoch kann es vorkommen, dass die Simulation aufgrund hoher Rechenanforderungen in dieser einen Sekunde Echtzeit weniger voranschreitet, nämlich z. B. nur 1/3 Sekunde. Würde der Testentwickler ohne Berücksichtigung dieser Diskrepanz das Signal nach einer Sekunde wieder auf 0 setzen, wäre der Testablauf nicht synchron mit der Simulation.

Um eine korrekte Synchronisation zu gewährleisten, wird gemäß dem vorliegenden Ausführungsbeispiel nach jedem Python-Befehl überprüft, ob die abgelaufene Simulationszeit kürzer als die tatsächliche Testzeit ist. In diesem Fall wartet der Python-Interpreter, bis die Simulation die entsprechende Zeit erreicht hat. So muss der Test im genannten Beispiel tatsächlich 3 Sekunden in Echtzeit warten, um eine Sekunde Simulationszeit zu ermöglichen.

Maßgeblich ist dabei unter anderem, dass keine feste Zeitddauer gewartet wird, sondern ein kontinuierliches Polling stattfindet. Hierbei wird nach jedem Python-Befehl geprüft, ob die Simulation langsamer ist. Ist dies der Fall, wartet der Python-Interpreter, bis die Simulationszeit mit der Testzeit übereinstimmt, bevor der nächste Befehl ausgeführt wird. Diese Methode stellt sicher, dass auch Schwankungen in der Simulationsberechnungsgeschwindigkeit während des Tests berücksichtigt und ausgeglichen werden, wodurch die Synchronisation zwischen Testablauf und Simulation gewährleistet wird.

Unter Bezugnahme auf Fig. 1, in der schematisch der Ablauf eines solchen Verfahrens gemäß einem bevorzugten Ausführungsbeispiel der Erfindung mit den Schritten S1, S2, S3a und S3b ersichtlich ist, stellt sich der Verfahrensablauf bei dieser Ausgestaltung wie folgt dar:
Schritt S1 (Übertragung, Start der Zeitmessung und Auslesen): Zunächst wird ein Eingangsdatum aus einer vordefinierten Menge von Eingangsdaten vom Test an die Simulation übertragen. Dabei gilt vorliegend, dass die Eingangsdaten aus der vorbestimmten Menge von Eingangsdaten in einer vorbestimmten Reihenfolge an die Simulation übertragen werden. Dies ermöglicht es der Simulation, basierend auf diesem Eingangsdatum in vorbestimmter Weise mindestens ein Ausgangsdatum zu ermitteln, das dann von dem Test ausgelesen und nachfolgend in üblicher Weise geprüft werden kann. Gleichzeitig mit der Übertragung des Eingangsdatums wird sowohl in der Testumgebung als auch in der Simulation die Zeitmessung gestartet. Dadurch können eine verstrichene Testzeit und eine verstrichene Simulationszeit ab dem Zeitpunkt der Datenübertragung erfasst und abgerufen werden. Die Testzeit verstreicht vorliegend in Echtzeit und die Simulationszeit verstreicht zumindest zeitweise in geringerer Zeit als in Echtzeit.

Schritt S2 (Abrufen und Vergleichen der Zeiten): In diesem Schritt werden die verstrichene Testzeit sowie die verstrichene Simulationszeit abgerufen und miteinander verglichen. Ziel ist es, zu bestimmen, ob die Simulationszeit der Testzeit entspricht oder diese sogar übersteigt. Dabei gilt, dass in diesem Schritt das Abrufen der verstrichenen Testzeit sowie das Abrufen der verstrichenen Simulationszeit und der Vergleich der verstrichenen Simulationszeit mit der verstrichenen Testzeit in vorbestimmten konstanten Zeitintervallen erfolgt, deren Zeitdauer der Zeitintervalle vorzugsweise der Zeitdauer der Pausenzeit entspricht. Grundsätzlich gilt allerdings, dass die Zeitdauer der Zeitintervalle einstellbar ist.

Schritt S3a (Entsprechung oder Überschreitung der Zeiten): Falls aus dem Vergleich hervorgeht, dass die Simulationszeit der Testzeit entspricht oder diese übersteigt, wird ein weiteres Eingangsdatum aus der vordefinierten Menge von Eingangsdaten von dem Test an die Simulation übertragen. Die Simulation ermittelt dann basierend auf diesem weiteren Eingangsdatum mindestens ein weiteres Ausgangsdatum. Alternativ wird das Verfahren beendet werden, wenn bereits alle Eingangsdaten aus der vordefinierten Menge an die Simulation übertragen wurden.

Schritt S3b (Unterschreitung der Simulationszeit): Sollte der Vergleich zeigen, dass die verstrichene Simulationszeit geringer ist als die verstrichene Testzeit, wird der Test für eine bestimmte Pausenzeit pausiert, während der die Testzeit angehalten wird. Nach dieser Pausenzeit werden die Schritte S2 und anschließend S3a bzw. S3b wiederholt.

Dieses Ablaufdiagramm veranschaulicht den Prozess der Synchronisation von Test- und Simulationszeiten und stellt sicher, dass die Simulation immer im Gleichschritt mit dem Test bleibt, indem es entweder die Datenübertragung fortsetzt oder den Test pausiert, je nachdem, wie die Testzeit im Verhältnis zur Simulationszeit steht.

Es ist möglich, dass der Test parallele Stränge aufweist, in denen jeweils wenigstens ein Eingangsdatum von dem Test an die Simulation übertragen wird. Dann gilt, dass die Schritte S1, S2, S3a und S3b zeitlich nebeneinander in parallelen Strängen ablaufen. Das ermöglicht die simultane Durchführung mehrerer Testprozesse innerhalb eines Tests. Jeder dieser Prozessstränge fungiert dabei quasi als eigenständiger Test, der parallel zu anderen Teststrängen abläuft. Diese parallele Ausführung verschiedener Teststränge kann die Effizienz des Gesamttests erheblich steigern und ermöglicht eine breitere sowie raschere Abdeckung verschiedener Testszenarien.

## Patentansprüche

1. Computerimplementiertes Verfahren zum Synchronisieren einer Simulation eines realen Geräts mit einem Test, wobei
die Simulation langsamer als beim Echtzeitbetrieb des realen Geräts in vordefinierter Weise auf von ihr empfangene Eingangsdaten hin solche Ausgangsdaten liefert, die das reale Gerät liefern würde, wenn es die Eingangsdaten empfangen hätte, und
der Test eine vorbestimmte Menge von Eingangsdaten umfasst, die an die Simulation übertragen werden sollen,
umfassend die folgenden Verfahrensschritte:
S1) Übertragen eines Eingangsdatums aus der vorbestimmten Menge von Eingangsdaten von dem Test an die Simulation, so dass von der Simulation auf das Eingangsdatum hin wenigstens ein Ausgangsdatum ermittelt wird, gleichzeitiges Starten einer Testzeit in dem Test sowie einer Simulationszeit in der Simulation, so dass eine verstrichene Testzeit und eine verstrichene Simulationszeit ab der Übertragung des Datums von dem Test an die Simulation abrufbar sind, und Übertragen des ermittelten Ausgangsdatums von der Simulation an den Test,
S2) Abrufen der verstrichenen Testzeit sowie Abrufen der verstrichenen Simulationszeit und Vergleich der verstrichenen Simulationszeit mit der verstrichenen Testzeit,
S3a) wenn der Vergleich erbracht hat, dass die verstrichenen Simulationszeit der verstrichenen Testzeit entspricht oder diese übersteigt: Übertragen eines weiteren Eingangsdatums aus der vorbestimmten Menge von Eingangsdaten von dem Test an die Simulation, so dass von der Simulation auf das weitere Eingangsdatum hin wenigstens ein weiteres Ausgangsdatum ermittelt wird, oder Beenden des Verfahrens, wenn alle Eingangsdaten aus der vorbestimmten Menge von Eingangsdaten bereits an die Simulation übertragen worden sind, und
S3b) wenn der Vergleich erbracht hat, dass die verstrichenen Simulationszeit geringer ist als die verstrichene Testzeit: Pausieren des Tests für eine Pausenzeit, in der der Ablauf der Testzeit angehalten wird, und Wiederholen von Schritt S2 und nachfolgend von Schritt S3a oder S3b nach der Pausenzeit.

2. Computerimplementiertes Verfahren nach Anspruch 1, wobei in Schritt S2 das Abrufen der verstrichenen Testzeit sowie das Abrufen der verstrichenen Simulationszeit und der Vergleich der verstrichenen Simulationszeit mit der verstrichenen Testzeit in vorbestimmten konstanten Zeitintervallen erfolgt.

3. Computerimplementiertes Verfahren nach Anspruch 2, wobei die Zeitdauer der Zeitintervalle der Zeitdauer der Pausenzeit entspricht.

4. Computerimplementiertes Verfahren nach Anspruch 2 oder 3, wobei die Zeitdauer der Zeitintervalle einstellbar ist.

5. Computerimplementiertes Verfahren nach einem der vorhergehenden Ansprüche, wobei die Testzeit in Echtzeit verstreicht.

6. Computerimplementiertes Verfahren nach einem der vorhergehenden Ansprüche, wobei die Simulationszeit zumindest zeitweise in geringerer Zeit als in Echtzeit verstreicht.

7. Computerimplementiertes Verfahren nach einem der vorhergehenden Ansprüche, wobei der Test parallele Stränge aufweist, in denen jeweils wenigstens ein Eingangsdatum von dem Test an die Simulation übertragen wird, so dass die Schritte S1, S2, S3a und S3b zeitlich nebeneinander in parallelen Strängen ablaufen.

8. Computerimplementiertes Verfahren nach einem der vorigen Ansprüche, wobei die Simulation eine Software-in-the-loop-Simulation ist.

9. Computerimplementiertes Verfahren nach einem der vorigen Ansprüche, wobei die Eingangsdaten aus der vorbestimmten Menge von Eingangsdaten in einer vorbestimmten Reihenfolge an die Simulation übertragen werden.

10. Nichtflüchtiges, computerlesbares Speichermedium mit darauf abgespeicherten Befehlen, die bei ihrer Ausführung auf einem Prozessor ein Verfahren nach einem der vorhergehenden Ansprüche bewirken.
